(19) **Europäisches Patentamt / European Patent Office / Office européen des brevets**

(11) **EP 3 940 767 A1**

(12) **EUROPEAN PATENT APPLICATION**
published in accordance with Art. 153(4) EPC

(43) Date of publication:
**19.01.2022 Bulletin 2022/03**

(21) Application number: **20769868.9**

(22) Date of filing: **10.03.2020**

(51) International Patent Classification (IPC):
**H01L 23/29** *(2006.01)*      **B32B 3/24** *(2006.01)*
**B32B 27/20** *(2006.01)*      **B32B 27/26** *(2006.01)*
**C08J 5/16** *(2006.01)*      **C08J 5/18** *(2006.01)*
**C08L 63/02** *(2006.01)*      **H01L 23/31** *(2006.01)*
**H01L 25/04** *(2014.01)*      **H01L 25/18** *(2006.01)*

(52) Cooperative Patent Classification (CPC):
**B32B 27/20; B32B 27/26; C08J 5/18; H01L 23/29; H01L 23/31; H01L 25/04; H01L 25/18**

(86) International application number:
**PCT/JP2020/010228**

(87) International publication number:
**WO 2020/184549 (17.09.2020 Gazette 2020/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **11.03.2019 JP 2019043970**
**14.03.2019 JP 2019046961**

(71) Applicant: **Kyocera Corporation**
**Kyoto-shi, Kyoto 612-8501 (JP)**

(72) Inventors:
- **FUJIWARA, Masakazu**
  **Kyoto-shi, Kyoto 612-8501 (JP)**
- **KUME, Akira**
  **Kyoto-shi, Kyoto 612-8501 (JP)**
- **KAZAMA, Shinichi**
  **Kyoto-shi, Kyoto 612-8501 (JP)**

(74) Representative: **Viering, Jentschura & Partner mbB**
**Patent- und Rechtsanwälte**
**Am Brauhaus 8**
**01099 Dresden (DE)**

(54) **MODULE, MODULE PRODUCTION METHOD, AND RESIN SHEET**

(57)    A module including: a substrate; components provided on the substrate; and a sealing material covering the substrate and the components; wherein a void is not present between the substrate and the sealing material, and between the components and the sealing material; and Equations (1) to (4) are satisfied,

$$100\ \mu m \leq T_A \leq 1300\ \mu m \qquad (1)$$

$$1 \leq d_2/d_1 \leq 11.43 \qquad (2)$$

$$50\ \mu m \leq T_B \leq 500\ \mu m \qquad (3)$$

$$d_2 = T_A \qquad (4)$$

where $T_A$ represents a thickness of the sealing material on a tallest component among the components, $T_B$ represents a thickness of the sealing material at a corner portion of the component, $d_1$ represents a distance from a location where an end portion of the sealing material abuts the substrate to a location where a thickness of the end portion of the sealing material reaches a constant thickness, and $d_2$ represents an end portion thickness where the thickness of the end portion of the sealing material reaches the constant thickness.

EP 3 940 767 A1

# FIG. 1

**Description**

Technical Field

The present disclosure pertains to a module, a method of producing the module, and a resin sheet used to seal a substrate and components of the module.

Background Art

In the related art, for a vehicle-mounted circuit device or the like, a location for installation is selected such that the electronic circuit is not damaged by the ingress of water, oil, dust, or the like. Furthermore, such a device adopts a structure in which the circuit substrate is sealed with a metal or resin. In a case where the circuit structure is sealed with a resin, various methods have been proposed, such as a transfer molding method using a solid epoxy resin composition, a potting method using a liquid epoxy resin composition, a silicone resin, or the like, a dispensing method, and a printing method (refer to Patent Document 1).

Citation List

Patent Literature

Patent Document 1: JP 6-61372 A

Summary

Technical Problem

However, with a molding method that does not use a mold, while it is possible to seal only a portion that requires sealing, if the resin composition exhibits fluidity, thermal resistance is reduced. Furthermore, when the resin composition exhibits fluidity, the resin composition may flow beyond the substrate, and potentially sealing a member not intended to be sealed. On the other hand, with a molding method in which a mold is used, thermal resistance and moisture resistance of the molded product can be increased. However, with such a method, a location that does not require sealing may potentially be sealed, thereby inhibiting reduction in the weight of the molded product.
One aspect of the present disclosure provides a module that excels in reliability and allows for weight reduction, and also provides a production method for the module, and a resin sheet used to seal a substrate and components of the module.

Solution to Problem

The inventors discovered that the problems described above can be solved by the following disclosure.
Namely, the present disclosure relates to the following.

[1] A module including: a substrate; components provided on the substrate; and a sealing material covering the substrate and the components; wherein a void is not present between the substrate and the sealing material, and between the components and the sealing material; and equations (1) to (4) are satisfied,

$$100\ \mu m \leq T_A \leq 1300\ \mu m \qquad (1)$$

$$1 \leq d_2/d_1 \leq 11.43 \qquad (2)$$

$$50\ \mu m \leq T_B \leq 500\ \mu m \qquad (3)$$

$$d_2 = T_A \qquad (4)$$

where $T_A$ represents a thickness of the sealing material on a tallest component among the components, $T_B$ represents a thickness of the sealing material at a corner portion of the component, $d_1$ represents a distance from a location where an end portion of the sealing material abuts the substrate to a location where a thickness of the end portion of the sealing material reaches a constant thickness, and $d_2$ represents an end portion thickness where the thickness of the end portion of the sealing material reaches the constant thickness.

[2] A method for producing the module described in any one of claims 1 to 3, the production method comprising:

(1) peeling off a release film provided on one side of a resin sheet, arranging the surface of the resin sheet from which the release film has been peeled off on a substrate on which a component is provided, and peeling off a release film provided on a surface of the resin sheet opposite the surface arranged on the substrate;
(2) pressing the resin sheet arranged on the substrate in step (1) from above with a jig, to fix the resin sheet temporarily to the substrate and component; and
(3) heating and curing the resin sheet which has been temporarily fixed to the substrate and component in step (2) to seal the substrate and component.

[3] A resin sheet having a melt viscosity at 100°C from 1.2 to 28 Pa·s, a thixotropic index of 4 or less at 100°C as calculated by Equation (I),

$$\text{Thixotropic Index (-)} = (\text{Melt Viscosity at } 1.0 \text{ (rad/s)})/(\text{Melt Viscosity at } 10.0 \text{ (rad/s)}) \text{ (I)}$$

and a permeation distance from 1 to 5 mm measured according to the following conditions,
(Measurement of Permeation Distance)
the permeation distance is measured as a distance that a resin composition melted at 100°C permeates between glass plates with a clearance of 50 $\mu$m.

[4] The resin sheet according to [3], in which a thickness of the resin sheet is from 30 to 2000 $\mu$m, and the resin sheet has a plurality of opening portions extending through the resin sheet in a thickness direction.
[5] The resin sheet according to [3], in which a thickness of the resin sheet is from 30 to 2000 $\mu$m, and the resin sheet has a shape that conforms to a shape of a sealing component in advance.
[6] The resin sheet according to [3], in which a release film is provided on one side of the resin sheet; and

an adhesive strength, measured according to the following measurement conditions, of a surface of the resin sheet in contact with the release film is greater than an adhesive strength, measured according to the following measurement conditions, of a surface of the resin sheet opposite the surface in contact with the release film by not less than 50%, where the adhesinve strength measurement conditions are as follows:
a release film is affixed to the resin sheet and cut to a size of 200 mm × 25 mm to prepare a test piece, and the adhesive strength of the test piece is measured using a tensile tester in accordance with JIS K6854-3: 1999.

Advantageous Effects of Invention

According to the present disclosure, a module that excels in reliability and allows for weight reduction, a method for producing the module, and a resin sheet used to seal a substrate and components of the module can be provided.

Brief Description of Drawings

FIG. 1 is a cross-sectional view illustrating an overall configuration of one embodiment of a module according to the present disclosure.
FIG. 2 is a flow diagram illustrating the detachment of a release film from a laminated resin sheet for use.
FIG. 3 is a flow diagram illustrating the detachment of a release film from a laminated resin sheet for use.
FIG. 4 is a cross-sectional view illustrating an overall configuration of one embodiment of a resin sheet according to the present disclosure.
FIG. 5 is a cross-sectional view illustrating an overall configuration of one embodiment of a resin sheet according to the present disclosure.
FIG. 6 is a cross-sectional view illustrating an overall configuration of one embodiment of a resin sheet according to the present disclosure.

FIG. 7 is a schematic configuration view illustrating a production device and a production method for producing a resin sheet according to the present disclosure.

FIG. 8 is a schematic cross-sectional view illustrating an example of a method for producing the resin sheet illustrated in FIG. 6.

FIG. 9 is a schematic cross-sectional view illustrating another example of a method for producing the resin sheet illustrated in FIG. 6.

Description of Embodiments

<Module>

A module of the present disclosure includes a substrate, components provided on the substrate, and a sealing material covering the substrate and the components. A void is not present between the substrate and the sealing material and between the components and the sealing material, and Equations (1) to (4) below are satisfied,

$$100 \ \mu m \le T_A \le 1300 \ \mu m \qquad (1)$$

$$1 \le d_2/d_1 \le 11.4 \qquad (2)$$

$$50 \ \mu m \le T_B \le 500 \ \mu m \qquad (3)$$

$$d_2 = T_A \qquad (4)$$

where $T_A$ represents a thickness of the sealing material on a tallest component among the components, $T_B$ represents a thickness of the sealing material at a corner portion of the component, $d_1$ represents a distance from a location where an end portion of the sealing material abuts the substrate to a location where a thickness of the end portion of the sealing material reaches a constant thickness, and $d_2$ represents an end portion thickness where the thickness of the end portion of the sealing material reaches the constant thickness.

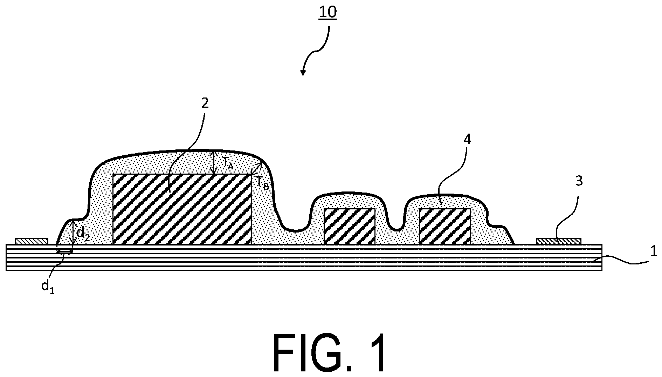

FIG. 1 is a cross-sectional view illustrating an overall configuration of one embodiment of a module according to the present disclosure. A module 10 in FIG. 1 includes a substrate 1, components 2, 3 provided on the substrate 1, and a sealing material 4 covering the substrate 1 and the component 2. As illustrated in FIG. 1, the module 10 has excellent reliability because there are no void between the substrate 1 and the sealing material 4 or between the component 2 and the sealing material 4.

A thickness $T_A$ of the sealing material on the tallest component is from 100 $\mu$m to 1300 $\mu$m. In a case where $T_A$ is less than 100 $\mu$m, a corner portion of the component 2 may be exposed, and reliability may be reduced, and if the $T_A$ exceeds 1300 $\mu$m, weight reduction of the module may not be possible. From such a perspective, $T_A$ may be not greater than 1000 $\mu$m, and may be not greater than 800 $\mu$m.

Melt viscosity and thixotropy of the sealing material may be adjusted to set the $T_A$ within the range described above.

Note that the $T_A$ can be determined by measuring 10 points at equal intervals in an image of a cross-section of the module photographed using a scanning electron microscope (SEM), and then calculating an average value thereof.

When $d_1$ represents a distance from a location where an end portion of the sealing material abuts the substrate to a location where a thickness of the end portion of the sealing material reaches a constant thickness, and $d_2$ represents an end portion thickness where the thickness of the end portion of the sealing material reaches a constant thickness, a ratio of $d_2/d_1$ is from 1 to 11.4. When $d_2/d_1$ is less than 1, the sealing material may protrude from the substrate, and may seal a member not intended to be sealed. Furthermore, masking and dam formation on portions not intended to be sealed becomes unnecessary. On the other hand, in a case where $d_2/d_1$ exceeds 11.4, the resin may not be sufficiently melted, resulting void formation, or the resin may not adhere strongly to the components and the substrate. From this perspective, $d_2/d_1$ may be from 1.3 to 5.7, or may be from 1.7 to 4.7.

The melt viscosity and thixotropy of the sealing material may be adjusted to set the $d_2/d_1$ within the range described above.

Note that the $d_1$ and $d_2$ can be measured from an image of a cross-section of the module photographed using a SEM.

The thickness $T_A$ of the sealing material on the tallest component and the end portion thickness $d_2$ at which

the thickness of the end portion of the sealing material reaches a constant thickness are identical. Identical thickness for the $T_A$ and the $d_2$ makes the thickness of the sealing material on the substrate and the components uniform, thereby enabling weight reduction.

The thickness $T_B$ of the sealing material 4 at the corner portion of the component 2 is from 50 $\mu$m to 500 $\mu$m. In a case where $T_B$ is less than 50 $\mu$m, the corner portion of the component 2 may be exposed, and reliability may be reduced, and in a case where $T_B$ exceeds 500 $\mu$m, weight reduction of the module may not be possible. From this perspective, $T_B$ may be less than or equal to 400 $\mu$m, and may be less than or equal to 300 $\mu$m.

The melt viscosity and thixotropy of the sealing material may be adjusted to set $T_B$ within the range described above.

Note that the $T_B$ can be measured from an image of a cross-section of the module photographed using a SEM.

$T_B$ is smaller than $T_A$, and may be from 5 to 85%, from 5 to 50%, or from 8 to 35% of $T_A$. In addition, when a thermoplastic film described below is provided on the sealing material, the $T_B$ may be from 50 to 85% or from 60 to 85% of $T_A$.

As illustrated in FIG. 1, the number of components 2 may be two or more, and the heights of the plurality of components 2 may be mutually the same or different. From the perspective of eliminating exposure at the corner portion, the height of the component 2 may be 3.0 mm or less, or may be 2.5 mm or less. Furthermore, a lower limit of the height of the component 2 is not particularly limited, and may be 50 $\mu$m or 100 $\mu$m.

(Substrate)

Examples of the substrate include metal substrates such as aluminum and iron plates, ceramic substrates, and organic resin substrates formed by impregnating a glass fiber base material with a thermosetting resin and curing the thermosetting resin. Among these, from the perspectives workability, low cost, and affinity with the sealing material, organic resin substrates formed by impregnating a glass fiber base material with a thermosetting resin and curing the thermosetting resin may be favorably used. The substrate may also have a solder resist on the surface.

The substrate may also be a circuit substrate having a patterned electrical conductor layer (circuit) formed on one or both sides of the substrate. Any method can be used to produce the circuit substrate as long as the circuit is formed by a conventional method.

(Components)

Examples of the components covered by the sealing material include devices such as semiconductor elements, resistors, diodes, capacitors, high frequency devices, and acceleration sensors. Furthermore, examples of components that are not covered by the sealing material include heat-radiating members, through openings, and through-holes.

(Sealing Material)

The sealing material may be a cured product of a resin sheet.

From the perspectives of production and transportation of the resin sheet, when sealing is implemented with a single resin sheet, the sealing area of the sealing material in a planar direction of the substrate may be $2.5 \times 10^5$ mm$^2$ or less, may be $2.25 \times 10^5$ mm$^2$ or less, and may be $2.025 \times 10^5$ mm$^2$ or less. When sealing an area that is larger than the area of one resin sheet, a plurality of resin sheets may be used.

<Module Production Method>

The method for producing the module of the present disclosure is not particularly limited, and an example thereof is a sheet sealing method in which a resin sheet is used. The sheet sealing method is not particularly limited as long as the sheet sealing method is a known method. An example is a production method that includes: (1) peeling off a release film provided on one side of a resin sheet, arranging the surface of the resin sheet from which the release film has been peeled off on a substrate on which a component is provided, and peeling off a release film provided on a surface of the resin sheet opposite the surface arranged on the substrate (first step); (2) pressing the resin sheet arranged on the substrate in step (1) from above with a jig, to fix the resin sheet temporarily to the substrate and component (second step); and (3) heating and curing the resin sheet which has been temporarily fixed to the substrate and component in step (2) to seal the substrate and component (third step).

(First Step)

In the first step, first, a release film provided on one side of the resin sheet is peeled off.

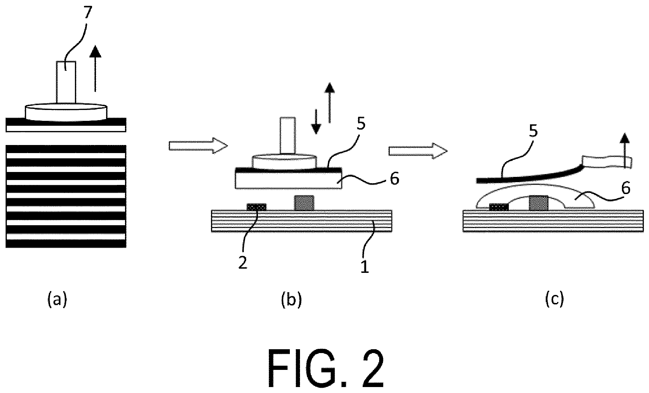

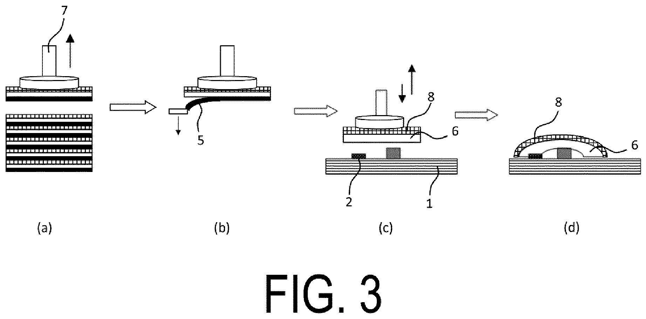

FIGS. 2 and 3 are flow diagrams illustrating the detachment of the release film peeled from a laminated resin sheet.

The release film may have different peeling strengths against a resin sheet between the front and the back. When the peeling strength for the side of the release film opposite the resin sheet is smaller, in a case where, for example, a resin sheet having a release film on one side is stored in a stacked or rolled form, the resin sheet is peeled from a release film of another resin sheet at the same time that the resin sheet starts moving toward the substrate. Therefore, a step of peeling off the release film can be omitted (see FIG. 2).

Next, the surface of the resin sheet from which the release film was peeled off is arranged on a substrate on which a component is provided.

When a thermoplastic film is provided on one side of a resin sheet, a side of the resin sheet opposite the thermoplastic film is laid on the substrate on which the components are provided. Furthermore, when a plurality of opening portions that go through the resin sheet in the thickness direction (and have a tapered cross section) are provided, a side having narrower openings of the opening portions of the resin sheet is laid on the substrate on which the components are provided. When the resin sheet is laid on the substrate, the substrate may be at ambient temperature, or may be heated to a temperature from 80 to 95°C.

Lastly, a release film provided on the side of the resin sheet opposite the surface arranged on the substrate is peeled off. In a case where a thermoplastic film is provided on one surface of the resin sheet, a release film may not be required on the thermoplastic film, and thus the step of peeling off the release film can be omitted (see FIG. 3).

(Second Step)

In the second step, the resin sheet arranged on the substrate in the first step is pressed from above with a jig, and the resin sheet is temporarily fixed to the substrate and the component. Thus, a void is less likely to remain in the resin sheet.

Examples of the jig include a roller. Furthermore, in the resin sheet, the shape of the component that is to be sealed may be formed in advance.

(Third Step)

In the third step, the resin sheet temporarily fixed to the substrate and the component in the second step is heated and cured to seal the substrate and the component.

The heating and curing are normally performed at ordinary pressure (no pressurization), but may also be performed in a vacuum heating furnace. The heating temperature may be from 80 to 150°C or from 90 to 120°C. The heating time may be from 10 minutes to 2.0 hours, or may be from 30 minutes to 1.0 hour.

The sealing of the component by the resin sheet can also be achieved by, for example, heating and curing at a low pressure of 0.5 MPa or less, or by heating and curing after the resin sheet has been temporarily adhered to the component by press molding or heat lamination molding. A temporarily adhered body can be preferably produced under lamination conditions at this time, the conditions including a temperature range from 30 to 180°C and a heating and pressurizing roller speed of 0.1 to 5 m/minute.

The module of the present disclosure produced in this manner can be used in consumer applications, in-vehicle applications, industrial applications, and the like. Specifically, the module of the present disclosure can be suitably used in a control circuit device mounted in an engine room or transmission, etc. of an automobile, or in a control circuit device for a motorcycle.

<Resin Sheet>

The resin sheet of the present disclosure is used to seal a substrate and a component.

A thickness of the resin sheet of the present disclosure may be from 30 to 2000 μm or from 100 to 1000 μm. When the thickness of the resin sheet is not less than 30 μm, the thermosetting resin composition itself, which is used to form the resin sheet, has good handling property. Furthermore, in particular, when a component is produced by adhering a resin sheet to a component element body, wrinkles and cracks are less likely to occur in the resin sheet during processing of the component and during transportation and movement thereof. On the other hand, when the thickness of the resin sheet is less than or equal to 2000 μm, the resin sheet has good handling property, cracks are less likely to occur in the resin sheet after curing, and a reduction in the thickness of the components is more easily achieved.

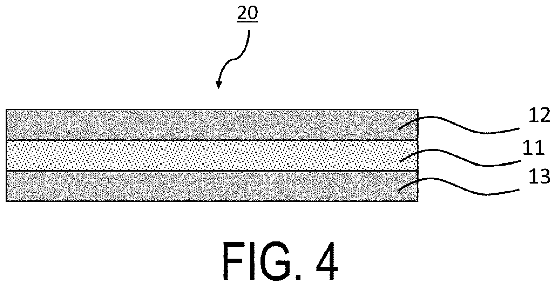

FIGS. 4 to 6 are cross-sectional views illustrating an overall configuration of one embodiment of a resin sheet according to the present disclosure. Here, in the present disclosure, as illustrated in FIGS. 4 to 6, a sheet in which a release film or another film such as a thermoplastic film is provided on a resin sheet is referred to as a sealing sheet.

As illustrated in FIG. 4, a release film 12 may be provided on one side of a resin sheet 11 of the present disclosure. Further, a release film 13 may also be provided on a side of the resin sheet 11 opposite the release film 12. Note that sealing sheets 20 may be stacked and stored, but may also be wound on a roll and used in a roll shape. When the release film has different peeling strengths between the front and back sides, the release film 12 can be omitted.

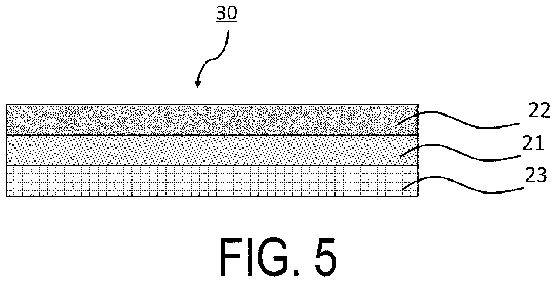

As illustrated in FIG. 5, a resin sheet 21 may be provided with a thermoplastic film 23 on a side of the resin sheet 21 opposite a release film 22. Here, the resin sheet 21 of the present disclosure may be integrated with the thermoplastic film 23 into single body. Additionally, the resin sheet 21 may be formed so as to be closely adhered to the release film 22. In this case, there may be no release film on the thermoplastic film side.

When the thermoplastic film 23 is integrated on one side of the resin sheet 21, components on the substrate surface are sealed by the resin sheet 21, and thereby improving surface protection properties such as thermal resistance, wear resistance, water resistance, and oil resistance, and enhancing long-term reliability of the components. Furthermore, the number of times that a release film is peeled from the resin sheet can be reduced to one.

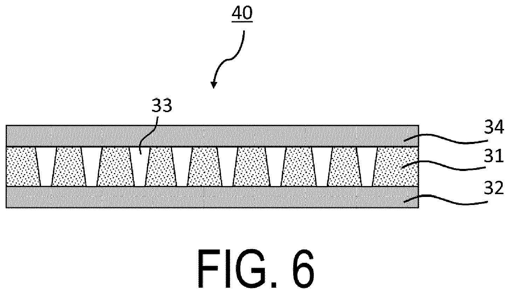

A resin sheet 31 of the present disclosure illustrated in FIG. 6 is provided on a release film 32, and the resin sheet 31 includes a plurality of opening portions 33 that go through the resin sheet 31 in the thickness direction. The opening portion 33 may have a tapered cross section in the thickness direction of the resin sheet 31. Furthermore, the resin sheet 31 may be provided with a release film 34 on a side of the resin sheet 31 opposite the release film 32.

The resin sheet 31 and the release film 32 may be formed in close contact.

For a case in which the resin sheet 31 has a plurality of opening portions that go through the resin sheet 31 in the thickness direction, when the resin sheet is closely adhered on the substrate and heated and cured, a void can escape the opening portions, and thus a void is less likely to remain in the cured product of the resin sheet.

The shape of the opening portion 33 is not particularly limited, and may be a through-hole or a through-groove. FIG. 6 illustrates a case in which the opening portion 33 is a through-hole.

The number of the through-holes and positions of the through-holes provided in the resin sheet 31 are not particularly limited and may depend on a size of the substrate to be used and a shape and number of the components to be mounted. However, from the perspective of reducing voids, a ratio of a total area of the through-holes to a total surface area of the resin sheet 31 may be from 1 to 20%.

Moreover, a groove length of the through-grooves and the number of through-grooves provided in the resin sheet 31 is not particularly limited and may depend on the size of the substrate to be used and the shape and number of components to be mounted. However, from the perspective of reducing voids, a ratio of a total area of the grooves to the total surface area of the resin sheet 31 may be from 1 to 20%. The position of the through-grooves provided in the resin sheet 31 is not particularly limited, but the through-grooves may be provided in parallel to one side of the resin sheet 31.

In the resin sheet of the present disclosure, a shape that conforms to the shape of the components to be sealed may be formed in advance.

The resin sheet of the present disclosure includes a thermosetting resin composition. The thermosetting resin composition is not particularly limited, but examples of the thermosetting resin in the thermosetting resin composition include epoxy resins, acrylic resins, urethane resins, melamine resins, and phenol resins. The thermosetting resin composition may be a thermosetting resin composition containing an epoxy resin, and may be a thermosetting resin composition containing (A) an epoxy resin, (B) an epoxy resin curing agent, (C) a curing accelerator, and (D) an inorganic filler.

The epoxy resin of the constituent (A) is not particularly limited, but may include (A-1) a liquid bisphenol type epoxy resin and (A-2) a solid polyfunctional epoxy resin having a softening point of 95°C or lower.

The liquid bisphenol type epoxy resin of the constituent (A-1) is not particularly limited as long as the it has two or more epoxy groups per molecule. Examples thereof include bisphenol A and bisphenol F type epoxy resins. Specific examples of the liquid bisphenol A type epoxy resin include "EPOMIK (trade name) R140P" (epoxy equivalent of 188) available from Mitsui Chemicals, Inc., "DER383" (epoxy equivalent of 190) available from The Dow Chemical Company, and "jER (trade name) 807" (epoxy equivalent of 170) and "JER (trade name) 828" (epoxy equivalent of 190) available from Mitsubishi Chemical Corporation.

A single type of these liquid bisphenol type epoxy resins may be used, or two or more types may be combined and used.

Note that in the present disclosure, the liquid bisphenol type epoxy resin refers to a bisphenol type epoxy resin that is in a liquid form at 25°C.

A softening point of the solid polyfunctional epoxy resin of the constituent (A-2) is 95°C or lower. When the softening point of the solid polyfunctional epoxy resin of the constituent (A-2) exceeds 95°C, the resin sheet tends to easily crack and chip. From this perspective, the softening point of the constituent (A-2) may be 80°C or lower, or may be 70°C or lower. Furthermore, a lower limit of the softening point of the constituent (A-2) is normally approximately 40°C.

Note that in the present disclosure, the softening point can be measured in accordance with the softening point test method (ring and ball method) stipulated by JIS K2207. Specifically, a prescribed ring is filled with a sample, the filled ring is then supported horizontally in a water bath or a glycerin bath, a prescribed ball is placed in the center of the sample and the bath temperature is raised at a rate of 5°C per minute. The temperature at which the sample, which wraps the ball around, contacts the bottom plate of the ring base is defined as the softening point.

As for the constituent (A-2), examples of the solid polyfunctional epoxy resin having a softening point of 95°C or lower include mixtures of aralkyl epoxy resins containing a biphenyl skeleton, and mixtures of dicyclopentadiene epoxy resins. Examples of commercially available products of the solid polyfunctional epoxy resin having a softening point of 95°C or lower include "NC3000 (softening point of 57°C)" and "NC3000H (softening point of 70°C)" available from Nippon Kayaku Co., Ltd., and "YDCN704 (softening point of 90°C)" available from Tohto Chemical Industry Co., Ltd.

When the liquid bisphenol type epoxy resin (A-1) and the solid polyfunctional epoxy resin (A-2) having a softening point of 95°C or lower are used in combination, that is, two kinds of epoxy resins having different melting points are blended, a thermosetting resin composition that is a solid at room temperature (25°C) and exhibits liquid behavior at high temperatures can be obtained.

A mass ratio [(A-1)/(A-2)] of the constituent (A-1) to the constituent (A-2) may be in a range from 10/90 to 30/70. When the mass ratio [(A-1)/(A-2)] is 10/90 or higher, cracking and chipping of the resin sheet do not easily occur, and when the mass ratio [(A-1)/(A-2)] is 30/70 or lower, a resin sheet can be easily formed.

A content of the epoxy resin of the constituent (A) may be from 50 to 90 mass% or from 60 to 80 mass% of the total amount of the thermosetting resin composition. Furthermore, in a case where the module of the present disclosure is used as a vehicle-mounted circuit device, the content of the epoxy resin of the constituent (A) may be from 10 to 30 mass% or from 10 to 20 mass% of the total amount of the thermosetting resin composition.

The epoxy resin curing agent of the constituent (B) is not particularly limited, and any of those conventionally used as a curing agent for an epoxy resin can be appropriately selected and used. Examples thereof include amine-based curing agents, phenol-based curing agents, acid anhydride-based curing agents, and the like. Examples of the amine-based curing agent include dicyandiamide, m-phenylenediamine, 4,4'-diaminodiphenylmethane, 4,4'-diaminodiphenylsulfone, m-xylylene diamine, and other such aromatic diamines. Examples of the phenol-based curing agent include phenol novolac resins, cresol novolac resins, bisphenol A type novolac resins, and triazine-modified phenol novolac resins. Examples of the acid anhydride-based curing agent include alicyclic acid anhydrides such as methylhexahydrophthalic anhydride, aromatic acid anhydrides such as phthalic anhydride, aliphatic acid anhydrides such as aliphatic dibasic acid anhydrides (PAPA), and halogen-based acid anhydrides such as chlorendic anhydride. One type of these epoxy resin curing agents may be used, or two or more types may be used in combination.

From perspectives such as a balance between curability and the physical properties of the cured resin, in terms of an equivalent ratio with respect to the epoxy resin of the constituent (A), the content of the epoxy resin curing agent of the constituent (B) may ordinarily be an equivalent ratio of approximately from 0.5 to 1.5, and may be selected in an equivalent ratio range from 0.7 to 1.3.

The curing accelerator of the constituent (C) is not particularly limited, and any curing accelerator can be appropriately selected and used from among those conventionally used as curing accelerators for epoxy resins. Examples of the curing accelerator include ureas such as aromatic dimethyl urea, aliphatic dimethyl urea, 3-(3,4-dichlorophenyl)-1,1-dimethyl urea (DCMU), 3-(3-chloro-4-methylphenyl)-1,1-dimethyl urea, and 2,4-bis (3,3-dimethylureido)toluene; imidazole compounds such as 2-ethyl-4-methylimidazole, 1-benzyl-2-methylimidazole, 2-methylimidazole, 2-ethylimidazole, 2-isopropylimidazole, 2-phenylimidazole, and 2-phenyl-4-methylimidazole; 2,4,6-tris(dimethylaminomethyl)phenol, a boron trifluoride-based amine complex, and triphenylphosphine. One type of these curing accelerators may be used, or two or more types may be used in combination.

From perspectives such as a balance between curing acceleration and the physical properties of the cured resin, per 100 parts by mass of the epoxy resin of the constituent (A), the content of the curing accelerator of the constituent (C) may ordinarily be approximately from 0.1 to 10 parts by mass, and may be selected within a range from 0.4 to 5 parts by mass.

The inorganic filler of the constituent (D) is not particularly limited, and an inorganic filler that is ordinarily used can be used, including, for example, silicas such as fused silica, spherical silica, and crystalline silica; alumina; and metal hydrates such as aluminum hydroxide and magnesium hydroxide.

From the perspectives of workability during production and the efficiency of filling gaps with the thermosetting resin composition, a mass average particle size of the inorganic filler of the constituent (D) may be in the range from 1 to 30 μm or may be in a range from 1.5 to 20 μm. Note that in the present disclosure, the mass average particle size refers to a median value (D50) measured by a laser diffraction scattering method (for example, device name: SALD-3100 available from Shimadzu Corporation).

The inorganic filler of the constituent (D) may be aluminum hydroxide, spherical silica, or crystalline silica. An example of aluminum hydroxide is "H42M (mass average particle size: 1.5 μm)" available from Showa Denko K.K., examples of spherical silica include "MRS-15 (mass average particle size: 15 μm)" available from Tatsumori Ltd. and "FB-959 (mass average particle size: 25 μm)" available from Denki Kagaku Kogyo K.K., and an example of crystalline silica is "Fuselex RD-8 (mass average particle size: 18 μm)" available from Tatsumori Ltd. Note that the metal hydrate can also serve as a flame retardant, but in the present disclosure, the metal hydrate is handled as an inorganic filler of the constituent (D).

A content of the inorganic filler of the constituent (D) may be from 10 to 80 mass%, from 10 to 60 mass%, from 10 to 50 mass%, or from 20 to 40 mass% of the total amount of the thermosetting resin composition. When the content of the inorganic filler of the constituent (D) is 10 mass% or greater, the fluidity during melting does not become excessively high, protrusion of the thermosetting resin composition from the sealing region can be prevented, and warping and twisting when the thermosetting resin composition is cured do not easily occur. On the other hand, when the content of the inorganic filler of the constituent (D) is not greater than 50 mass%, fluidity during melting is improved, and unfilled locations in the sealing region are less likely to occur.

Furthermore, when the module of the present disclosure is used as a vehicle-mounted circuit device, the content of the inorganic filler of the constituent (D) may be from 30 to 80 mass% or from 50 to 80 mass% of the total amount of the thermosetting resin composition. When the content of the inorganic filler of the constituent (D) is 30 mass% or greater, in a case where a resin sheet is used to seal the substrate and the components, the fluidity of the melted resin does not become excessively high, protrusion from the range to be sealed does not easily occur, and the wear resistance of the cured product surface can be improved. On the other hand, when the content of the inorganic filler of the constituent (D) is not greater than 80 mass%, cracking and chipping do not easily occur in the resin sheet, the fluidity during melting is improved, and the unfilled locations are unlikely to occur in the gaps.

The thermosetting resin composition may further contain a flame retardant (E). The flame retardant of the constituent (E) is not particularly limited, and for example, a phosphorus compound can be used.

Examples of the phosphorus compound include phosphazene compounds; 9,10-dihydro-9-oxa-10-phosphaphenanthrene-10-oxide and derivatives thereof; phosphate ester compounds; and phosphate ester amides. Examples of the phosphazene compound include "SPB-100" available from Otsuka Chemical Co., Ltd.

One type of these flame retardants may be used, or two or more types may be used in combination.

A content of the flame retardant of the constituent (E) depends on the type of flame retardant, but from the perspective of a balance between flame retardancy and other physical properties, the content may be from 1 to 30 mass% or from 2 to 10 mass% of the total amount of the thermosetting resin composition.

A content of the constituents (A), (B), (C), and (D) in the thermosetting resin composition may be 70 mass% or greater, may be 80 mass% or greater, or may be 90 mass% or greater.

From the perspective of filling properties, the thermosetting resin composition can contain a coupling agent as necessary. Examples of the coupling agent include silane-based, titanate-based, and aluminum-based coupling agents, and of these, a silane-based coupling agent may be favorably used.

A content of the silane-based coupling agent may be approximately from 0.03 to 5.0 mass% or from 0.1 to 2.5 mass% based on the total amount of the thermosetting resin composition.

The thermosetting resin composition may include, as appropriate and within a range that does not inhibit the effect of the present disclosure, a low stress agent, such as a silicone rubber, a silicone gel or other such organic powder, a silicone-modified epoxy resin, a phenol resin, and a methyl methacrylate-butadiene-styrene copolymer or other such thermoplastic resin; a viscosity-reducing diluent, such as n-butyl glycidyl ether, phenyl glycidyl ether, styrene oxide, t-butyl phenyl glycidyl ether, dicyclopentadiene diepoxide, phenol, cresol, and t-butyl phenol; a wetting enhancing agent such as a nonionic surfactant, a fluorosurfactant, and silicone oil; and a defoaming agent.

Note that the plasticity of the thermosetting resin composition constituting the resin sheet at ambient temperature (25°C) may be from 60 to 98. In a case where the plasticity is 60 or greater, overflow of the thermosetting resin composition can be suppressed, bleeding to an area outside of the sealing region can be reduced, and outer appearance defects and contamination around the sealing region can be prevented. In addition, when the plasticity is not greater than 90, an increase in voids in the sealing region can be suppressed, and the occurrence of adherence defects and filling defects can be suppressed.

Note that plasticity in the present disclosure is measured by a parallel plate plastometer based on a method in accordance with JIS K6249: 2003.

The resin sheet may be formed by stacking two or more resin sheets of different compositions and integrating it to single body, and for example, resin sheets having different degrees of plasticity, and resin sheets with different amounts of inorganic filler may be combined.

(Preparation of the Thermosetting Resin Composition)

The method for preparing the thermosetting resin composition is not particularly limited, and for example, the thermosetting resin composition can be prepared as described below. First, as the constituent (A), a liquid bisphenol type epoxy resin (A-1) and a solid polyfunctional epoxy resin (A-2) having a softening point of 95°C or lower, an epoxy resin curing agent (B), a curing accelerator (C), an inorganic filler (D), and other various optional constituents added as necessary are uniformly mixed using a high-speed mixer or the like, and are then thoroughly kneaded using a kneader, a two-roll kneader, a continuous kneader, or the like. The kneading temperature may be approximately from 50 to 110°C.

After cooling, the kneaded product thus obtained is ground to form a clump-shaped resin. Note that when a sheet-like thermosetting resin composition is used to form the resin sheet, the kneaded product is pressed at a temperature of approximately 50 to 100°C and a pressure from 0.5 to 1.5 MPa using a molding machine and molded into a sheet.

(Physical Properties of the Resin Sheet)

The resin sheet of the present disclosure has melt viscosity at 100°C from 1.2 to 28Pa·s. If the melt viscosity at 100°C is less than 1.2 Pa·s, fluidity increases, the resin sheet may flow beyond the substrate causing a protrusion and potentially sealing a member not intended to be sealed. If the melt viscosity exceeds 28 Pa·s, the fluidity is low, and the resin sheet may fail to seal a member intended to be sealed. From this perspective, the melt viscosity at 100°C may be from 4 to 18 Pa s or from 7 to 12 Pa s.

Note that the melt viscosity at 100°C can be measured using a rheometer, and specifically, the melt viscosity can be measured by the method described in the examples.

The resin sheet of the present disclosure has a thixotropic index at 100°C of 4 or less as calculated by Equation (I) below.

$$\text{Thixotropic Index (-)} = (\text{Melt Viscosity at } 1.0 \text{ (rad/s))}/(\text{Melt Viscosity at } 10.0 \text{ (rad/s))} \qquad \text{(I)}$$

In a case where the thixotropic index at 100°C exceeds 4, the fluidity of the resin sheet decreases, and a void may easily occur. From this perspective, the thixotropic index at 100°C may be less than or equal to 3.5, and may be less than or equal to 3. The lower limit of the thixotropic index at 100°C is less than 1.

Note that the thixotropic index at 100°C can be measured specifically by the method described in the examples.

The resin sheet of the present disclosure has a permeation distance from 1 to 5 mm when measured according to the following conditions.

(Measurement of Permeation Distance)

A distance that a resin composition melted at 100°C permeates between glass plates with a clearance of 50 μm is measured.

In a case where the permeation distance is less than 1 mm, fluidity when the resin composition is formed into a resin sheet may decrease, and a void may easily occur, and if the permeation distance exceeds 5 mm, the fluidity when the resin composition is formed into a resin sheet may become excessive, and the resin sheet may easily flow beyond the range to be sealed. From this perspective, the permeation distance may be from 1 to 3 mm or from 1 to 2 mm.

Note that the permeation distance can be measured specifically by the method described in the examples.

The gelling time of the resin sheet of the present disclosure may be from 40 to 60 minutes or from 40 to 50 minutes.

Note that the gelling time of the resin sheet can be measured by the method described in the examples.

The resin sheet of the present disclosure may have a Shore A hardness at 25°C from 60 to 95, from 70 to 95, or from 80 to 95. When the Shore A hardness at 25°C is not less than 60, the resin sheet can have a moderate hardness for formation of the opening portions in the resin sheet. In addition, adhesion of the resin sheet to the jig may be prevented and blocking in the formed opening portions may also be prevented. On the other hand, if the Shore A hardness at 25°C is not greater than 95, breakage and cracking of the resin sheet during handling can be suppressed.

Note that the Shore A hardness at 25°C can be measured by the method described in the examples.

A glass transition temperature of the cured product of the resin sheet of the present disclosure may be 120°C or higher, 130°C or higher, or 150°C or higher. When the glass transition temperature of the cured product is 120°C or higher, degradation of components due to an increase in the outside air temperature and heat generated from the heat-radiating members can be suppressed.

The glass transition temperature of the cured product can be set to the temperature or higher by appropriately adjusting the content of the epoxy resin of the constituent (A).

Note that the glass transition temperature can be measured in accordance with JIS K7121: 2012, and specifically, the glass transition temperature can be measured by the method described in the examples.

A pencil hardness of the cured product of the resin sheet of the present disclosure may be 4H or greater, or may be 5H or higher.

Note that the pencil hardness here refers to a pencil hardness measured in accordance with the pencil hardness test stipulated in JIS K5600-5-4: 1999. The pencil hardness can be measured by the method described in the examples.

The cured product of the resin sheet of the present disclosure may have a flexural modulus at 25°C from 10 to 30 GPa, from 12 to 28 GPa, or from 15 to 25 GPa. When the flexural modulus at 25°C of the cured product is not less than 10 GPa, the wear resistance of the cured product of the resin sheet is improved, and when the flexural modulus is not greater than 30 GPa, warping of the substrate is suppressed, and the occurrence of cracks due to stress caused by vibration or the like can be suppressed.

The flexural modulus at 25°C can be set to within the range described above by appropriately adjusting the content of both the epoxy resin of the constituent (A) and the inorganic filler of the constituent (D).

Note that the flexural modulus at 25°C can be measured in accordance with JIS K6911: 2006, and specifically, the flexural modulus can be measured by the method described in the examples.

A flexural strength (Fi) of the cured product of the resin sheet of the present disclosure after immersion for 240 hours in a gear oil at 150°C may be 90% or higher or 95% or higher relative to an initial flexural strength ($F_0$). When a ratio of $F_1$ to $F_0$ is greater than or equal to 90%, the oil resistance of the cured product of the resin sheet is excellent.

The $F_0$ and $F_1$ can be measured by the method described in the examples.

When a release film is provided on one surface of the resin sheet of the present disclosure, an adhesive strength ($T_1$) of a side of the resin sheet in contact with the release film according to the following measurement conditions is greater, by 50% or greater, than an adhesive strength ($T_2$) of a side of the resin sheet opposite the side in contact with the release film.

(Adhesive Strength Measurement Conditions)

A release film is affixed to the resin sheet and cut to a size of 200 mm × 25 mm to prepare a test piece, and the adhesive strength of the test piece is measured using a tensile tester in accordance with JIS K6854-3: 1999.

When $T_1$ is 50% or greater with respect to $T_2$, in a case where another release film is not provided on a side of the resin sheet opposite the release film, when the resin sheet having the release film on one side is stored in a stacked or rolled form, even if the resin sheet adheres to a release film of another resin sheet, the resin sheet can be easily peeled off from the release film of the other resin sheet. Therefore, it is sufficient that a release film be provided on one side of the resin sheet, and in the first step of the method for producing the module, the release film is peeled off from the resin sheet only once. In addition, when the resin sheet is used in producing a component by adhering to a component element body, the resin sheet can form a good cured film, sealing the component in an excellent manner, and thus an improvement in reliability of the component can be expected as a result of the surface protection after sealing.

The adhesive strength ($T_1$) of the side of the resin sheet in contact with the release film may be from 0.15 to 1.0 N/100 mm, or may be from 0.2 to 0.95 N/100 mm. In addition, the adhesive strength ($T_2$) of the side of the resin sheet opposite the side in contact with the release film may be from 0.1 to 0.5 N/100 mm, or may be from 0.15 to 0.45 N/100 mm. When both $T_1$ and $T_2$ are within the ranges described above, even when a resin sheet having a release film on one side is stored in a rolled form and then adhered to a release film of another resin sheet, the resin sheet can be easily peeled off from the release film of the other resin sheet. Note that in the case of a resin sheet having a release film on one side, the release film is arranged such that the side of the release film having high peeling strength is in contact with the resin sheet. In addition, even when the resin sheet is cut, stacked, and stored, and then sheets are retrieved one by one using an automatic machine or the like, each resin sheet can be easily peeled off and laid onto a substrate on which a component is mounted thereby sealing the substrate and component.

A peeling strength ($T_3$) of the side of the release film in contact with the resin sheet may be from 0.2 to 0.8 N/100 mm or from 0.25 to 0.75 N/100 mm in accordance with the following measurement conditions. In addition, a peeling strength ($T_4$) of the side of the release film opposite the side in contact with the resin sheet may be from 0.1 to 0.4 N/100 mm, or may be from 0.12 to 0.32 N/100 mm. When both $T_3$ and $T_4$ are within the ranges described above, $T_1$ is greater than $T_2$ by 50% or greater.

(Peeling Strength Measurement Conditions)

An acrylic pressure-sensitive adhesive layer of a polyester pressure-sensitive adhesive tape is adhered to a release film and then cut to a size of 200 mm × 100 mm to prepare a test piece. The peeling strength of the test piece is measured by a 180° peel test with a peeling speed of 300 mm/minute and a peeling distance of 50 mm in accordance with JIS K6854-2: 1999.

The residual adhesion of the side of the release film in contact with the resin sheet may be 80% or higher, or may be 90% or higher. The residual adhesion of 80% or higher provides sufficient releasability, and improves workability.

Note that the residual adhesion is an index for determining the transfer of the release agent. Typically, the residual adhesion is a ratio of the pressure-sensitive adhesive force after a pressure-sensitive adhesive tape has been affixed to a release agent-coated surface or the like and then peeled off, divided by an initial pressure-sensitive adhesive force. Specifically, the residual adhesion can be measured by the method described in the examples.

(Thermoplastic Film)

A thermoplastic film is provided on one main side of the resin sheet. When a module is formed, the thermoplastic film is provided on the side of the sealing material covering the substrate and components of the module. The thermoplastic film is not particularly limited as long as melting and deformation of the thermoplastic film occur in the prescribed manner when forming the module. Examples of such thermoplastic films include heat-resistant films such as polyimide films, polyamide-imide films, aramid films, and polyether ether ketone films. Among these, polyimide films and polyether ether ketone films are favorably used.

An example of a commercially available polyimide film product is Kapton (trade name) (product name, available from DuPont-Toray Co., Ltd.), and an example of a commercially available polyether ether ketone film product is EXPPEK (product name, available from Kurabo Industries Ltd.).

The thickness of the thermoplastic film may be from 3 to 15 $\mu$m. When the thickness of the thermoplastic film is 3 $\mu$m or greater, the substrate surface can be sufficiently protected. Furthermore, the thermoplastic film having the thickness of not greater than 15 $\mu$m yields the favorable conformability to the uneven shape of the components on the substrate, when the resin sheet is adhered to the side of a substrate on which the components are mounted and then heated and sealed.

The thermal shrinkage of the thermoplastic film after heating for 30 minutes at 250°C may be 1% or less, or may be 0.1% or less. Workability of the resin sheet is favorable when the thermal shrinkage is 1% or less.

Note that the thermal shrinkage is a value measured in accordance with JIS C2151: 2006.

(Release Film)

The release film may be provided on one main surface of the resin sheet and formed in close contact with the resin sheet. A film base material constituting the release film is not particularly limited as long as the film base material does not melt and deform when forming a resin sheet on the release film, and examples of such film base materials that can be used include polyethylene, polystyrene, polyethylene terephthalate, methacrylic, polyimide, polyether ether ketone, polycarbonate, polyvinyl alcohol-based resins, polypropylene-based resins, polymethylpentene-based resins, silicone-based resins, and fluororesins. Among these, polyethylene terephthalate, polyvinyl alcohol-based resins, polypropylene-based resins, polymethylpentene-based resins, silicone-based resins, and fluororesins may be favorably used.

The thickness of the release film may be from 10 to 100 $\mu$m. When the thickness of the release film is not less than 10 $\mu$m, wrinkles and the like are less likely to occur when the release film is in close contact with a resin sheet, and handling properties are improved. On the other hand, when the thickness of the release film is not greater than 100 $\mu$m, releasability during use becomes favorable.

(Resin Sheet Production Method)

The method for producing the resin sheet is not particularly limited, and the resin sheet can be produced, for example, through a step of kneading the constituent components of the thermosetting resin composition at a temperature from 50 to 110°C to prepare a kneaded product, and a step of supplying the kneaded product onto a release film, and pressing the release film and the kneaded product to integrally mold the release film and the kneaded product into the shape of a sheet.

Note that when a thermoplastic film is provided on the side of the resin sheet opposite the release film, in the production method, the kneaded product is supplied between the release film and the thermoplastic film; and the release film, the kneaded product, and the thermoplastic film are pressed and thereby integrally molded into the shape of a sheet.

The supply form of the kneaded product is not particularly limited, and the kneaded product can be supplied in a clump shape, a sheet shape, or in a molten state. Furthermore, the kneaded product and the release film may be molded in batches, or may be continuously molded using a heat press, pressurizing roller, or the like.

The resin sheet may also be produced by a method in which the kneaded product is supplied onto a release film, and the release film and kneaded product are integrally molded into a sheet shape by a pressurizing roller. A pair of pressurizing rollers may be such that a dimension of a gap therebetween can be adjusted, and for example, the pressurizing rollers may have a diameter from from 20 to 60 mm and a gap dimension from approximately 5 to 500 $\mu$m. Furthermore, as molding conditions for integration, the temperature may be set to a range from 30 to 180°C, and the rotational speed of the pressurizing roller may be set from 0.1 to 5 m/min. A favorable resin sheet can be produced by setting the molding conditions to such a temperature range and rotational speed of the pressurizing rollers.

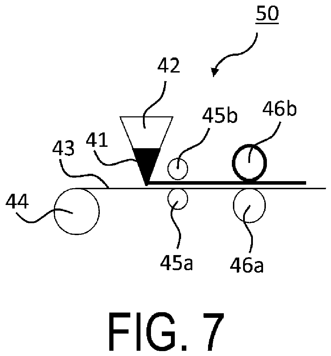

FIG. 7 is a schematic configurational view illustrating a production device and a production method for producing a resin sheet according to the present disclosure. A production device 50 includes, for example, a supply device 42 that converts a thermosetting resin composition 41 from a clump shape to a molten state and supplies the molten thermosetting resin composition 41, and a release film roll 44 to which a release film 43 is wound and from which the release film 43 is supplied.

As illustrated in FIG. 7, the thermosetting resin composition 41, which has been converted from a clump shape to a molten state, is continuously supplied from the supply device 42 onto the release film 43 that is conveyed from the release film roll 44 to a pair of guide rollers 45a, 45b. Further, this supplied product is passed between a pair of pressurizing rollers 46a, 46b.

A resin sheet 11 provided with a release film 12 on one side can be produced in this manner. The sheet produced by integration of the resin sheet 11 and the release film 12 may be cut and then stacked and stored, or may be wound onto a roll and used in a roll state.

A method of producing the resin sheet 11 continuously using a pressurizing roller was described above. However, the resin sheet 11 may be also produced, for example, by laminating a release film and a kneaded product, in this order, onto a support body such as a press machine, and pressing at conditions including a temperature of approximately 50 to 100°C and a pressure from 0.5 to 1.5 MPa.

(Formation of Opening Portions)

(1) Through-holes having a tapered shape are formed in the resin sheet in the following manner.

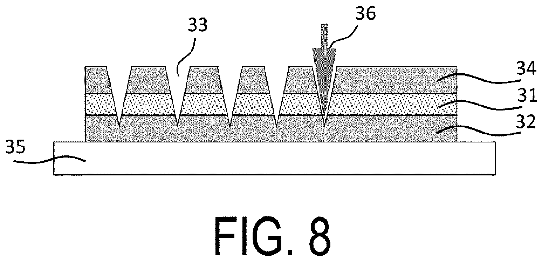

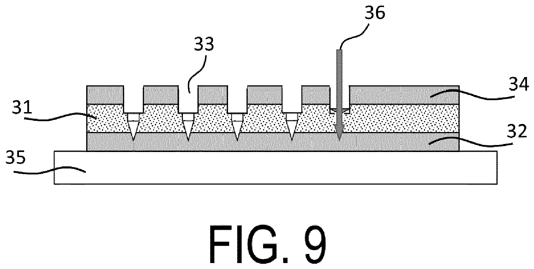

FIG. 8 is a schematic cross-sectional view illustrating an example of a method for producing the resin sheet illustrated in FIG. 6, and FIG. 9 is a schematic cross-sectional view illustrating another example of a method for producing the resin sheet illustrated in FIG. 6.

A resin sheet 31 produced as described above is fixed to a work stand 35, and a tapered hole is formed using a hole opener 36. A through-hole 33 may penetrate to the release film 32 as illustrated in FIG. 8, or may penetrate through the release film 32. Examples of the hole opener 36 include a punch and a drill.

Note that in the present disclosure, in the tapered hole, a narrower opening is defined as a lower hole, and a wider opening is defined as an upper hole. In a resin sheet having a tapered hole, the side of the resin sheet having the lower hole is laid on a substrate on which a component is provided.

The through-hole 33 may be formed such that the area of the lower hole is smaller than the area of the upper hole by 50% or greater. When the through-hole 33 is formed, in which the area of the lower hole is smaller than the area of the upper hole by 50% or greater, a void can be removed from the upper holes when the resin sheet 31 is heated and melted, and a void is less likely to remain in the cured product of the resin sheet 31.

Furthermore, the lower hole diameter of the formed through-hole 33 may be from 10 to 50% of the thickness of the resin sheet 31. When the lower hole diameter is not smaller than 10% of the thickness of the resin sheet 31, air bubbles can be sufficiently removed. When the lower hole diameter is not greater than 50% of the thickness of the resin sheet 31, the hole can be sufficiently filled with resin.

The number of through-holes 33 to be formed depends on the size of the substrate to be used and the shape and quantity of the mounted components, and therefore the number of through-holes 33 to be formed is not limited. However, from the perspective of reducing voids, the proportion of the total area of the through-holes 33 may be from 1 to 20% of the area of the resin sheet 31.

For the method of opening holes, the through-hole 33 is opened in the resin sheet 31 using a small diameter drill, after which a hole is drilled to the middle of the resin sheet 31 using a large diameter drill. As illustrated in FIG. 9, a drill 36 having a small diameter and large diameter cutting edge may be used. Furthermore, the resin sheet 31 may be punched with a small diameter punch, after which a hole may be drilled to the middle of the resin sheet 31 using a large diameter drill. At this time, the tapered shape may be a stepped shape.

Additionally, a through-hole having a tapered shape may be formed with a router.

(2) Through-grooves having a tapered shape are formed in the resin sheet in the following manner.

The resin sheet produced as described above is fixed to a work stand, and a tapered groove is formed in the resin sheet using a hole opener.

The groove formation method includes forming a narrow groove that penetrates the resin sheet using a router or the like, and then forming a thick groove penetrating to the middle of the resin sheet. A tapered groove may be formed continuously, and the groove may penetrate to as far as the release film.

With regard to the tapered groove to be formed, the groove width at the wide side of the tapered shape may be from 10 to 50% of the thickness of the resin sheet. When the groove width is set to not smaller than 10% of the thickness of the resin sheet, air bubbles can be sufficiently removed until the through-grooves are blocked, and voids are less likely to remain in the cured product of the resin sheet. When the groove width is not greater than 50% of the thickness of the resin sheet, the resin can sufficiently fill the groove.

The length and number of through-grooves to be formed depend on the size of the substrate to be used and the shape and quantity of the mounted components, and therefore the number of through-grooves to be formed is not limited. However, from the perspective of reducing voids, the proportion of the total area of the through-grooves may be from 1 to 20% of the area of the resin sheet.

Examples

Next, aspects of the present disclosure are specifically described through examples. However, the present disclosure is not limited in any way to these examples.

(Preparation of the Thermosetting Resin Composition)

Various constituents of the types and blending amounts described in Table 1 were charged into a kneader and these constituents were kneaded and mixed for 1 hour at 75°C. Thus, thermosetting resin compositions of Examples 1 to 4 and Comparative Examples 1 and 2 were prepared. Note that a blank cell in Table 1 indicates that the given component was not blended.
The plasticity at ambient temperature (25°C) of the thermosetting resin compositions of Examples 1 to 4 was 96.
Note that the plasticity was measured using a parallel plate plastometer (available from Ueshima Seisakusho Co., Ltd., model number: VR-6155) based on a method in accordance with JIS K6249: 2003.
The various constituents used in Examples 1 to 4 and Comparative Examples 1 and 2 were as follows.

[Constituents (A)]

(A-1) Liquid bisphenol type epoxy resin: jER (trade name) 828 (product name), a bisphenol A type epoxy resin (epoxy equivalent: 190) available from Mitsubishi Chemical Corporation
(A-2) Solid polyfunctional epoxy resin having a softening point of 95°C or lower: NC3000 (product name), a biphenyl skeleton-containing polyfunctional epoxy resin (epoxy equivalent: 285, softening point: 57°C) available from Nippon Kayaku Co., Ltd.

[(B) Epoxy Resin Curing Agent]

DICY: dicyandiamide available from Nippon Carbide Industries Co., Inc.

[(C) Curing Accelerator]

U-CAT3512T: aromatic dimethyl urea, available from San-Apro Ltd.

[(D) Inorganic Filler]

H42M: aluminum hydroxide (mass average particle size: 1.5 $\mu$m) available from Showa Denko K.K.
FB-959: spherical silica (mass average particle size: 25 $\mu$m), available from Denki Kagaku Kogyo K.K.

The thermosetting resin compositions, resin sheets, and modules (circuit devices) prepared in Examples 1 to 4 and Comparative Examples 1 and 2 were subjected to the following measurements. The results are shown in Table 1.

(1) Measurement of the thickness $T_A$ of the sealing material on the tallest component

The thickness $T_A$ of the sealing material on the tallest component was measured at ten points at equal intervals in an image of a cross-section of the module photographed using a scanning electron microscope (SEM, product name: JSM-7600F available from JEOL Ltd.), and the average value was calculated and used as the thickness thereof.

(2) Measurement of the thickness $T_B$ of the sealing material at a corner portion of the component

The thickness $T_B$ of the sealing material at a corner portion of the component was measured from an image of a cross-section of the module photographed using a scanning electron microscope (SEM, product name: JSM-7600F available from JEOL Ltd.).

(3) Measurement of $d_2/d_1$

$d_1$ represents a distance from a location where an end portion of the sealing material abuts the circuit substrate to a location where the thickness of the end portion of the sealing material reached a constant thickness,, and $d_2$ denotes an end portion thickness where the thickness of the end portion of the sealing material reached a constant thickness. The $d_1$ and $d_2$ were measured from an image of a cross-section of the module photographed using a scanning electron microscope (SEM, product name: JSM-7600F available from JEOL Ltd.), and the ratio of $d_2/d_1$ was calculated.

(4) Melt Viscosity

The prepared thermosetting resin composition was heated from 25°C to 100°C at a ramp rate of 20°C per minute and then maintained at 100°C for 5 minutes, and the melt viscosity was measured using a rheometer (model number: ARES-G2 available from TA Instruments Inc.).

(5) Thixotropic Index

The melt viscosity at 1.0 (rad/s) and the melt viscosity at 10.0 (rad/s) were measured at a temperature of 100°C using a rheometer (available from TA Ta Instruments Inc.), and the thixotropic index was calculated from the following equation (I).

$$\text{Thixotropic Index (-)} = (\text{Melt Viscosity at } 1.0 \text{ (rad/s)})/(\text{Melt Viscosity at } 10.0 \text{ (rad/s)}) \qquad (I)$$

(6) Permeation Distance

An amount of 0.5 g of the prepared thermosetting resin composition was arranged on a glass plate provided with clearance of 50 $\mu$m, and the distance of permeation of the thermosetting resin composition melted at 100°C between glass plates provided with clearance of 50 $\mu$m was measured.

(7) Shore A Hardness

The Shore A hardness of the resin sheet at 25°C was measured using a Shore hardness meter (model number: HD-N1110 available from Ueshima Seisakusho Co., Ltd.).

Example 1

The thermosetting resin composition was cooled to 30°C, after which a clump-shaped resin was obtained. The obtained clump-shaped resin was brought into a molten state and supplied onto a surface of a release film (product name: NSD, available from Fujimori Kogyo Co., Ltd., thickness of 38 $\mu$m, peeling strength: front side $(T_3)$ 0.62 N/100 mm, back side $(T_4)$ 0.30 N/100 mm, $T_3$ being 52% greater than $T_4$, residual adhesion: front side 95%), the surface of the side having a peeling strength of 0.62 N/100 mm, and while the molten resin was supplied onto the surface of the release film, the film and molten resin were passed between a pair of pressurizing rollers and were thereby molded into an integrated form. Note that the diameter of the pressurizing rollers was 60 mm, and the roll gap (gap dimension) was from 400 to 600 $\mu$m. Molding was performed at a temperature of 70°C and a rotational speed of the pressurizing rollers of 2 m/min. Through this, a sealing sheet having a release film on one side of a resin sheet formed from the thermosetting resin composition was prepared. The resin sheet had a thickness of 500 $\mu$m and a resin content of 88 vol.%.

The adhesive strength $(T_1)$ of the side of the resin sheet in contact with the release film and the adhesive strength $(T_2)$ of the side of the resin sheet opposite the side in contact with the release film were determined according to the following measurement conditions using the prepared sealing sheet. $T_1$ was 0.4 N/100 mm, and $T_2$ was 0.2 N/100 mm.

(Adhesive Strength Measurement Conditions)

A release film was affixed to the resin sheet and cut to a size of 200 mm $\times$ 25 mm to prepare a test piece, and the adhesive strength of the test piece was measured using a tensile tester in accordance with JIS K6854-3: 1999.

Additionally, when 100 sheets of the prepared sealing sheet were stacked and stored for 48 hours at 25°C, and then continuously used by an automatic feeder, the sealing sheets were found to excel in supply performance and releasability.

The peeling strength of the release film was a value that was determined by the following measurement conditions.

The release film was placed on a horizontal stand, an acrylic pressure-sensitive adhesive layer of a polyester pressure-sensitive adhesive tape (product number 31B available from Nitto Denko Corporation) having the acrylic pressure-sensitive adhesive layer was affixed to the release film, and then the release film with the tape was cut to a size of 200 mm × 100 mm to form a test piece. A load was placed on the test piece so as to be 20 g/cm$^2$ from above the polyester pressure-sensitive adhesive tape, and the test piece was aged for 20 hours at 70°C. After aging, the test piece was used for a 180° peel test with a tensile tester at a peeling speed of 300 mm/minute and a peeling distance of 50 mm in accordance with JIS K6854-2: 1999. The average peeling load in a region where the peeling had stabilized was divided by the width of 100 mm of the polyester pressure-sensitive adhesive tape, and thus the peeling force was obtained.

Moreover, the residual adhesion of the release film was a value that was determined under the following measurement conditions.

The release film was placed on a horizontal stand, an acrylic pressure-sensitive adhesive layer of a polyester pressure-sensitive adhesive tape (product number 31B available from Nitto Denko Corporation) having the acrylic pressure-sensitive adhesive layer was affixed to the release film, and then the release film with the tape was cut to a size of 200 mm × 100 mm to form a test piece. A load was placed on the test piece so as to be 20 g/cm$^2$ from above the polyester pressure-sensitive adhesive tape, and the test piece was aged for 20 hours at 70°C. After aging, the release film of the test piece was peeled off, and the polyester pressure-sensitive adhesive tape was compression-bonded to a stainless steel plate by rolling with a 2 kg rubber roller back and forth three times, and then the product was heat treated for 2 hours at 70°C. Next, the adhesive force F was measured according to the method stipulated by JIS-C-2107: 2011 (adhesive force to stainless steel plate, 180° peel method). A percentage ($F/F_2 \times 100$) of the adhesive force F relative to the adhesive force $F_2$ when the polyester pressure-sensitive adhesive tape was directly adhered to and peeled from a stainless steel plate was determined as the residual adhesion (%).

The release film was peeled off from the sealing sheet having a sheet width of 1.95 mm, the prepared resin sheet was oriented to face the side of a circuit substrate with a component and then placed thereon so as to cover the component. Thereafter heating was performed for 20 minutes at 120°C, and the resin sheet was fluidized and then cured. As a result, a circuit device in which the components were covered by a cured product (sealing material) of the resin sheet was obtained.

The resin sheet generally exhibited excellent handling properties, and the cross-sectional shape of the sealing material, and the cracking resistance and peeling resistance when cutting were also favorable.

Example 2

The thermosetting resin composition was cooled to 30°C, after which a clump-shaped resin was obtained. The obtained clump-shaped resin was brought into a molten state, and then supplied between two films, namely a thermoplastic film (product name: Kapton (trade name) 50EN available from DuPont-Toray Co., Ltd.: thickness of 12.5 μm, thermal shrinkage of 0.01% after heating at 250°C for 30 minutes) and a release film (product name: NSD, available from Fujimori Kogyo Co., Ltd., thickness of 38 μm), and subsequently passed between pressurizing rollers and integrally molded. The two films were supplied by respective rolls including one roll on which was wound the thermoplastic film, and another roll on which was wound the release film. Note that the diameter of the pressurizing rollers was 60 mm, and the roll gap (gap dimension) was from 100 to 300 μm. Molding was performed at a temperature of 70°C and a rotational speed of the pressurizing rollers of 2 m/min. As a result, a sealing sheet having a thermoplastic film on one side of a resin sheet formed from the thermosetting resin composition, and also having a release film on a side of the resin sheet that is opposite the thermoplastic film, was obtained Note that the combined thickness of the resin sheet and the thermoplastic film was 200 μm, and the resin content of the resin sheet was 88 vol.%.

Additionally, when 100 sheets of the obtained sealing sheet were stacked and stored for 48 hours at 25°C, and then continuously used by an automatic feeder, the sealing sheets were found to excel in supply performance and releasability.

The thermal shrinkage of the thermoplastic film after heating for 30 minutes at 250°C was measured in accordance with JIS C2151: 2006.

The release film was peeled off from the sealing sheet having a sheet width of 1.95 mm, the resin sheet side of the sealing sheet was oriented to face a sealing region (including components) of the side of a circuit substrate with components, and then the sealing sheet was placed thereon so as to cover the sealing region. Thereafter heating was performed for 20 minutes at 120°C, and the resin sheet was fluidized and then cured. As a result, a circuit device in which the sealing region was covered by a cured product (sealing material) of the resin sheet was obtained.

Furthermore, when the circuit device was visually observed, unfilled portions were not seen in the sealing region, peeling of the sealing material was not observed, and surface protection was found to be excellent.

Example 3

The thermosetting resin composition was cooled to 30°C, after which a clump-shaped resin was obtained. The obtained clump-shaped resin was brought into a molten state and supplied onto a release film (product name: NSD, available from Fujimori Kogyo Co., Ltd., thickness of 38 $\mu$m), and while the resin was supplied onto the release film, the resin and release film were passed between a pair of pressurizing rollers and integrally molded. Note that the diameter of the pressurizing rollers was 60 mm, and the roll gap (gap dimension) was from 400 to 600 $\mu$m. Molding was performed at a temperature of 70°C and a rotational speed of the pressurizing rollers of 2 m/min. Through this, a sealing sheet having a release film on one side of a resin sheet (thickness of 962 $\mu$m, surface area of 211600 mm$^2$) formed from the thermosetting resin composition was obtained. Note that the obtained sealing sheet was 460 mm long, 460 mm wide, and 500 $\mu$m thick, and had a resin content of 88 vol.%.

The obtained sealing sheet was fixed to a work stand, and tapered through-holes with an upper hole diameter of 1.0 mm and a lower hole diameter of 0.2 mm (total surface area of the lower holes: 4230 mm$^2$) were formed in the resin sheet using a drill.

The release film was peeled off from the sealing sheet, the side of the prepared resin sheet having the narrower openings (lower holes) of the through-holes was oriented to face the side of a circuit substrate with a component and then placed thereon so as to cover the component. Thereafter heating was performed for 40 minutes at 120°C, and the resin sheet was fluidized and then cured. As a result, a circuit device in which the components were covered by a cured product (sealing material) of the resin sheet was obtained.

The resin sheet generally exhibited good handling properties, and when the obtained circuit device was visually observed, void formation was not observed in the sealing material.

Example 4

A sealing sheet was prepared in the same manner as in Example 3, and the release film side of the sealing sheet prior to the formation of through-holes was fixed to a work stand, and tapered through-grooves having an upper groove width of 1.5 mm and a lower groove width of 0.3 mm (total surface area of the lower grooves of 6300 mm$^2$) were formed in the resin sheet using a router.

The release film was peeled off from the sealing sheet, the side of the prepared resin sheet having the narrower openings (lower grooves) of the through-grooves was oriented to face the side of a circuit substrate with a component and then placed thereon so as to cover the component. Thereafter, heating was performed for 40 minutes at 120°C, and the resin sheet was fluidized and then cured. As a result, a circuit device in which the components were covered by a cured product (sealing material) of the resin sheet was obtained.

The resin sheet generally exhibited good handling properties, and when the obtained circuit device was visually observed, void formation was not observed in the sealing material.

Comparative Example 1

The thermosetting resin composition was cooled to 30°C, after which a clump-shaped resin was obtained. The obtained clump-shaped resin was brought into a molten state and supplied onto a release film (product name: NSD, available from Fujimori Kogyo Co., Ltd., thickness of 38 $\mu$m), and while the resin was supplied onto the release film, the resin and release film were passed between a pair of pressurizing rollers and integrally molded. Note that the diameter of the pressurizing rollers was 60 mm, and the roll gap (gap dimension) was from 850 to 1150 $\mu$m. Molding was performed at a temperature of 70°C and a rotational speed of the pressurizing rollers of 2 m/min. Through this, a sealing sheet having a release film on one side of a resin sheet (thickness of 962 $\mu$m, surface area of 211600 mm$^2$) formed from the thermosetting resin composition was obtained. Note that the obtained sealing sheet was 460 mm long, 460 mm wide, and 1.0 mm thick, and had a resin content of 27.8 vol.%.

Comparative Example 2

The thermosetting resin composition was cooled to 30°C, after which a clump-shaped resin was obtained. The obtained clump-shaped resin was brought into a molten state and supplied onto a release film (product name: NSD, available from Fujimori Kogyo Co., Ltd., thickness of 38 $\mu$m), and while the resin was supplied onto the release film, the resin and release film were passed between a pair of pressurizing rollers and integrally molded. Note that the diameter of the pressurizing rollers was 60 mm, and the roll gap (gap dimension) was from 100 to 300 $\mu$m. Molding was performed

at a temperature of 70°C and a rotational speed of the pressurizing rollers of 2 m/min. Through this, a sealing sheet having a release film on one side of a resin sheet (thickness of 962 $\mu$m, surface area of 211600 mm$^2$) formed from the thermosetting resin composition was obtained. Note that the obtained sealing sheet was 460 mm long, 460 mm wide, and 200 $\mu$m thick, and had a resin content of 90.4 vol.%.

Table 1

[Table 1-1]

| | | | Units | Example 1 | Example 2 | Example 3 | Example 4 | Comparative Example 1 | Comparative Example 2 |
|---|---|---|---|---|---|---|---|---|---|
| Thermo setting Resin Composition | (A-1) Liquid bisphenol type epoxy resin | jER (trade name) 828 | parts by mass | 15 | 15 | 15 | 15 | 15 | 15 |
| | (A-2) Solid polyfunctional epoxy resin having a softening point of 95°C or lower | NC3000 | parts by mass | 85 | 85 | 85 | 85 | 85 | 85 |
| | (B) Epoxy resin curing agent | DICY | parts by mass | 4 | 4 | 4 | 4 | 4 | 4 |
| | (C) Curing accelerator | U-CAT3512T | parts by mass | 4 | 4 | 4 | 4 | 4 | 4 |
| | (D) Inorganic filler | H42M | parts by mass | 47 | 47 | 47 | 47 | 56 | 25 |
| | | FB-959 | parts by mass | | | | | 510 | |

EP 3 940 767 A1

[Table 1-2]

| | | | Units | Example 1 | Example 2 | Example 3 | Example 4 | Comparative Example 1 | Comparative Example 2 |
|---|---|---|---|---|---|---|---|---|---|
| $T_A$ | | | μm | 579 | 220 | 560 | 554 | 1030 | 100 |
| $T_B$ | | | μm | 121 | 182 | 83 | 76 | 990 | 5 |
| $d_2/d_1$ | | | - | 1.88 | 3.49 | 1.73 | 1.73 | 28.64 | 0.36 |
| Presence or absence of voids | | | - | Absent | Absent | Absent | Absent | Present | Absent |
| Melt viscosity | | | Pa·s | 10 | 10 | 10 | 10 | 30 | 2 |
| Thixotropic Index | | | - | 0.9 | 0.9 | 0.9 | 0.9 | 1.5 | 2.0 |
| Permeation distance | | | mm | 1.9 | 1.9 | 1.9 | 1.9 | 0.2 | 20 |
| Shore A hardness | | | - | 80 | 80 | 80 | 80 | 90 | _*1 |
| *1: Could not be measured because the tack was too strong. | | | | | | | | | |

Examples 5 to 8, Comparative Examples 3 to 5

Various constituents of the types and blending amounts described in Table 2 were charged into a kneader and these constituents were stirred and mixed for 1 hour at 75°C. Thus, each thermosetting resin composition was prepared. Note that a blank cell in Table 2 indicates that the given component was not blended.

Next, each thermosetting resin composition was cooled to 30°C, and then press molded using a molding machine under conditions of 70°C and 1.0 MPa to obtain a sheet having a thickness of 0.5 mm, and thereby various resin sheets formed from the thermosetting resin compositions were produced.

Components mounted on a glass epoxy circuit substrate (FR-4) were covered with the resin sheet, and then heated at a temperature of 100°C for 2 hours under ordinary pressure to fluidize the resin sheet, after which heating was further performed at a temperature of 150°C for 1 hour to cure the fluidized resin sheet, and under such conditions, the components were sealed by the resin sheet while a gap that was formed between the components and the substrate was maintained.

The constituents used in Examples 5 to 8 and Comparative Examples 3 to 5 were as follows.

[Constituents (A)]

- (A-1) Liquid bisphenol type epoxy resin: DER383J (product name), a bisphenol A type epoxy resin (epoxy equivalent: 190) available from The Dow Chemical Company
- (A-2) Solid epoxy resin having a softening point of 95°C or lower: NC3000 (product name), a biphenyl skeleton-containing polyfunctional epoxy resin (epoxy equivalent: 285, softening point: 57°C) available from Nippon Kayaku Co., Ltd.

[Thermosetting Resin Other than the Constituents (A)]

- POLYDAR 9516 (product name): an unsaturated polyester resin available from Takeda Pharmaceutical Co., Ltd.

[(B) Epoxy Resin Curing Agent]

- DICY: dicyandiamide available from Nippon Carbide Industries Co., Inc.

[Crosslinking Agent Other than the Constituent (B)]

- CJ3947: crosslinking agent available from Matsumoto Denko Co., Ltd.

[(C) Curing Accelerator]

- U-CAT3502T: aromatic dimethyl urea available from San-Apro Ltd.

[(D) Inorganic Filler]

- MRS-15: spherical silica (mass average particle size: 15 $\mu$m) available from Tatsumori Ltd.
- Fuselex RD-8: crushed silica (mass average particle size: 18 $\mu$m) available from Tatsumori Ltd.

[(E) Flame Retardant]

- SPB-100: phosphazene available from Otsuka Chemical Co., Ltd.

The various properties of Examples 5 to 8 and Comparative Examples 3 to 5 were determined according to the methods described below. The evaluation results are shown in Table 2.

<Thermosetting Resin Composition>

(1) Melt Viscosity

The thermosetting resin composition was heated from 25°C to 100°C at a ramp rate of 20°C per minute and then maintained at 100°C for 5 minutes, and the melt viscosity was measured using a rheometer (model number: ARES-G2 available from TA Instruments Inc).

(2) Permeation Distance

An amount of 0.5 g of the thermosetting resin composition was arranged on a glass plate provided with clearance of 50 $\mu$m, and the distance of permeation of the thermosetting resin composition melted at 100°C between glass plates provided with clearance of 50 $\mu$m was measured.

<Resin Sheet>

(3) Gelling Time

The time required for the resin sheet to become a gel in an oil bath at 100°C was measured in accordance with the test tube method of JIS C 2105: 2006.

(4) Thixotropic Index

The melt viscosity at 1.0 (rad/s) and the melt viscosity at 10.0 (rad/s) were measured at a temperature of 100°C using a rheometer (available from TA Ta Instruments Inc.), and the thixotropic index was calculated from Equation (I) below.

$$\text{Thixotropic Index (-)} = (\text{Melt Viscosity at } 1.0 \ (\text{rad/s}))/(\text{Melt Viscosity at } 10.0 \ (\text{rad/s})) \qquad (I)$$

<Cured Product>

(5) Glass Transition Temperature

Resin sheets were stacked and molded for 2 hours at 150°C using a heat press to create a 1.6 mm thick evaluation plate. The temperature of the resin plate was increased from room temperature (25°C) to 200°C (at a temperature increase rate of 10°C/minute) in a TMA/SS150 (available from Seiko Instruments Inc.), and the glass transition temperature was measured.

(6) Surface Hardness (Pencil Hardness)

The evaluation plate created in (5) above was cut to a size of 50 mm (lemgth) $\times$ 10 mm (width) to make test pieces. In accordance with JIS K5600-5-4: 1999, the pencil hardness was increased until scratches were made on the surface of the test pieces, and the hardest pencil hardness whewe no scratches were made was measured.

(7) Flexural Modulus

The evaluation plate created in (5) above was cut into a test piece having a size of 50 mm long $\times$ 10 mm wide, and the flexural modulus at 25°C was measured. To measure the flexural modulus, a load was applied with a precision universal testing machine (Autograph AG-IS available from Shimadzu Corporation, support-punch radius 0.3 mm, test speed: 1 mm/minute), and the flexural modulus was calculated in accordance with JIS K6911: 2006.

(8) Oil Resistance

The flexural strength of a test piece prepared in the same manner as the test piece used for measuring the flexural modulus of (7) was measured by the same method as in (7), and this measurement was used as an initial flexural strength ($F_0$). The test piece was subsequently immersed in a gear oil and left for 240 hours at 150°C. Next, the test piece was cooled to room temperature (25°C), after which the flexural strength was again measured, and this measurement was used as a flexural strength (Fi) after immersion for 240 hours in the 150°C gear oil, and the ratio of $F_1$ to $F_0$ was calculated.

<Electronic Circuit Device>

(9) Warpage Amount

A chip mounting surface of a glass epoxy circuit substrate (FR-4) having a chip mounted on one side and having a length of 100 mm, a width of 60 mm, and a thickness of 1.6 mm was covered with a resin sheet and sealed by heating and curing. The maximum lift-up height was measured when the sample was placed stationary on a flat plate.

(10) Wear Resistance Test

The circuit substrate sample prepared in (9) was placed in an aluminum tray and covered with sand, after which the tray was vibrated using a vibrating device, and surface changes due to the sand were visually observed.

A: Fine scratches were produced, but no large scratches were observed.
B: Large scratches were partially produced.
C: Numerous large scratches were produced.

Table 2

[Table 2-1]

| | | | Units | Examples | | | | Comparative Examples | | |
|---|---|---|---|---|---|---|---|---|---|---|
| | | | | 5 | 6 | 7 | 8 | 3 | 4 | 5 |
| Thermosetting Resin Composition | (A-1) Liquid bisphenol type epoxy resin | DER383J | parts by mass | 20 | 15 | 20 | 20 | | | 20 |
| | (A-2) Solid polyfunctional epoxy resin having a softening point of 95°C or lower | NC3000 | parts by mass | 80 | 85 | | 80 | | | 80 |
| | | NC3000H | parts by mass | | | 80 | | 100 | | |
| | Thermosetting resin other than the constituents (A) | Polymer 9516 | parts by mass | | | | | | 60 | |
| | (B) Epoxy resin curing agent | DICY | parts by mass | 4.0 | 4.5 | 4.0 | 4.0 | 4.0 | | 4.0 |
| | Crosslinking agent other than constituent (B) | CJ3947 | parts by mass | | | | | | 50 | |
| | (C) Curing accelerator | U-CAT3502T | parts by mass | 4.0 | 4.5 | 4.0 | 4.0 | 4.0 | | 4.0 |
| | (D) Inorganic filler | MRS-15 | parts by mass | 400.0 | 400.0 | 400.0 | | 400.0 | 400.0 | |
| | | Fuselex RD-8 | parts by mass | | | | 400.0 | | | |
| | (E) Flame retardant | SPB-100 | parts by mass | 20 | 20 | 20 | 20 | 20 | 20 | 20 |
| Content of inorganic filler (D) relative to total amount of thermosetting resin composition | | | mass% | 75.8 | 75.6 | 75.8 | 75.8 | 75.8 | 75.5 | 0.0 |

[Table 2-2]

| Properties | Item | Units | Examples | | | | Comparative Examples | | |
|---|---|---|---|---|---|---|---|---|---|
| | | | 5 | 6 | 7 | 8 | 3 | 4 | 5 |
| Resin Composition | Melt viscosity | Pa·s | 8.0 | 8.8 | 11.5 | 9.5 | 32.0 | 1.0 | 0.2 |
| | Permeation distance | mm | 1.7 | 1.9 | 1.1 | 1.5 | 0.7 | 6.0 | >25 |
| Sheet | Gelling time | min | 48 | 48 | 50 | 48 | 55 | 35 | 58 |
| | Thixotropic index | - | 0.9 | 0.8 | 0.7 | 0.7 | 1.8 | 5.2 | 4.1 |
| Cured product | Glass transition temperature | °C | 150 | 170 | 160 | 151 | 118 | - | 145 |
| | Surface hardness (pencil hardness) | - | 5H | 5H | 5H | 5H | 5H | 3H | 4H |
| | Flexural modulus (25°C) | GPa | 20 | 23 | 23 | 18 | 14 | 8 | 7 |
| | Oil resistance | % | 99 | 98 | 97 | 97 | 80 | 70 | 99 |
| Electronic Circuit Device | Warpage amount | mm | 1.0 | 0.5 | 1.0 | 1.0 | 2.0 | 1.0 | 5.0 |
| | Wear resistance test | - | A | A | A | A | A | C | B |

Reference Signs List

1 Substrate
2,3 Component
4 Sealing material
10 Module
20, 30, 40 Sealing sheet
6, 11, 21, 31 Resin sheet
5, 12, 13, 22, 32, 34 Release film
8, 23 Thermoplastic film
7 Adsorption device
33 Opening portion (tapered through-hole)
35 Work stand
36 Hole opener (drill)
50 Production device
41 Thermosetting resin composition
42 Supply device
43 Release film
44 Release film roll
45a, 45b Guide roller
46a, 46b Pressurizing roller

**Claims**

1. A module comprising:

a substrate;
components provided on the substrate; and
a sealing material covering the substrate and the components; wherein
a void is not present between the substrate and the sealing material, and between the components and the sealing material; and

Equations (1) to (4) are satisfied,

$$100 \ \mu m \leq T_A \leq 1300 \ \mu m \quad (1)$$

$$1 \leq d_2/d_1 \leq 11.43 \quad (2)$$

$$50 \ \mu m \leq T_B \leq 500 \ \mu m \quad (3)$$

$$d_2 = T_A \quad (4)$$

where $T_A$ represents a thickness of the sealing material on a tallest component among the components, $T_B$ represents a thickness of the sealing material at a corner portion of the component, $d_1$ represents a distance from a location where an end portion of the sealing material abuts the substrate to a location where a thickness of the end portion of the sealing material reaches a constant thickness, and $d_2$ represents an end portion thickness where the thickness of the end portion of the sealing material reaches the constant thickness.

2. The module according to claim 1, wherein the number of the components is two or more, a height of each component is 3.0 mm or less, the substrate has a solder resist on a surface, and a sealing area of the sealing material in a planar direction of the substrate is $2.5 \times 10^5 \ mm^2$ or less.

3. The module according to claim 1 or 2, wherein the sealing material comprises a cured product of a resin sheet.

4. A method for producing the module described in any one of claims 1 to 3, the production method comprising:

   (1) peeling off a release film provided on one side of a resin sheet, arranging the surface of the resin sheet, from which the release film has been peeled off, on a substrate on which a component is provided, and peeling off a release film provided on a surface of the resin sheet opposite the surface arranged on the substrate;
   (2) pressing the resin sheet arranged on the substrate in step (1) from above with a jig, to fix the resin sheet temporarily to the substrate and component; and
   (3) heating and curing the resin sheet which has been temporarily fixed to the substrate and component in step (2) to seal the substrate and component.

5. The method for producing a module according to claim 4, wherein in step (2), the jig is a roller.

6. The method for producing a module according to claim 4 or 5, wherein in step (3), curing conditions include no pressurization, a curing temperature from 80 to 150°C, and a curing time from 10 minutes to 2.0 hours.

7. A resin sheet having a melt viscosity at 100°C from 1.2 to 28 Pa·s, a thixotropic index of 4 or less at 100°C as calculated by Equation (I),

$$\text{Thixotropic Index (-)} = (\text{Melt Viscosity at } 1.0 \ (\text{rad/s}))/(\text{Melt Viscosity at } 10.0 \ (\text{rad/s})) \quad (I)$$

   and a permeation distance from 1 to 5 mm measured according to the following conditions,
   (Measurement of Permeation Distance)
   the permeation distance is measured as a distance that a resin composition melted at 100°C permeates between glass plates with a clearance of 50 $\mu$m.

8. The resin sheet according to claim 7, wherein a cured product of the resin sheet has a glass transition temperature of 120°C or higher, a pencil hardness of 4H or higher, a flexural modulus at 25°C from 10 to 30 GPa, and a flexural strength of 90% or higher after immersion in a 150°C gear oil for 240 hours, relative to an initial flexural strength.

9. The resin sheet according to claim 7 and 8, comprising a thermosetting resin composition including: (A-1) a liquid bisphenol type epoxy resin; (A-2) a solid polyfunctional epoxy resin having a softening point of 95°C or lower; (B) an epoxy resin curing agent; (C) a curing accelerator; and (D) an inorganic filler; wherein a mass ratio [(A-1)/(A-2)] of the constituent (A-1) to the constituent (A-2) is from 10/90 to 30/70, and a content of the constituent (D) is from 30 to 80 mass%.

10. The resin sheet according to any one of claims 7 to 9, wherein a thickness of the resin sheet is from 30 to 2000 $\mu$m, and the resin sheet has a plurality of opening portions extending through the resin sheet in a thickness direction.

11. The resin sheet according to any one of claims 7 to 9, wherein a thickness of the resin sheet is from 30 to 2000 $\mu$m, and the resin sheet has a shape that conforms to a shape of a sealing component in advance.

12. The resin sheet according to any one of claims 7 to 9, wherein a release film is provided on one side of the resin sheet; and
an adhesive strength, measured according to the following measurement conditions, of a surface of the resin sheet in contact with the release film is greater than an adhesive strength, measured according to the following measurement conditions, of a surface of the resin sheet opposite the surface in contact with the release film by not less than 50%, wherethe adhesive strength measurement conditions are as follows: a release film is affixed to the resin sheet and cut to a size of 200 mm $\times$ 25 mm to prepare a test piece, and the adhesive strength of the test piece is measured using a tensile tester in accordance with JIS K6854-3: 1999.

FIG. 1

(a)  (b)  (c)

# FIG. 2

FIG. 3

FIG. 4

FIG. 5

40

33

34
31
32

# FIG. 6

FIG. 7

FIG. 8

FIG. 9

## INTERNATIONAL SEARCH REPORT

| International application No. |
| --- |
| PCT/JP2020/010228 |

**A. CLASSIFICATION OF SUBJECT MATTER**
H01L 23/29(2006.01)i; B32B 3/24(2006.01)i; B32B 27/20(2006.01)i; B32B
27/26(2006.01)i; C08J 5/16(2006.01)i; C08J 5/18(2006.01)i; C08L
63/02(2006.01)i; H01L 23/31(2006.01)i; H01L 25/04(2014.01)i; H01L
25/18(2006.01)i
FI: H01L23/30 R; B32B3/24; B32B27/20 Z; B32B27/26; C08J5/16; C08J5/18
CFC; C08L63/02; H01L25/04 Z
According to International Patent Classification (IPC) or to both national classification and IPC

**B. FIELDS SEARCHED**

Minimum documentation searched (classification system followed by classification symbols)
H01L23/29; B32B3/24; B32B27/20; B32B27/26; C08J5/16; C08J5/18; C08L63/02;
H01L23/31; H01L25/04; H01L25/18

Documentation searched other than minimum documentation to the extent that such documents are included in the fields searched
| | |
| --- | --- |
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2012-54363 A (KYOCERA CHEMICAL CORP.) 15.03.2012 (2012-03-15) entire text, all drawings | 1–12 |
| A | JP 2008-177432 A (KYOCERA CHEMICAL CORP.) 31.07.2008 (2008-07-31) entire text, all drawings | 1–12 |
| A | JP 2015-34300 A (AJINOMOTO CO., INC.) 19.02.2015 (2015-02-19) entire text, all drawings | 1–12 |

☐ Further documents are listed in the continuation of Box C. ☒ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 01 June 2020 (01.06.2020) | 09 June 2020 (09.06.2020) |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**
Information on patent family members

International application No.

PCT/JP2020/010228

| Patent Documents referred in the Report | Publication Date | Patent Family | Publication Date |
|---|---|---|---|
| JP 2012-54363 A | 15 Mar. 2012 | WO 2011/148620 A1 entire text, all drawings CN 102725323 A KR 10-2013-0079311 A | |
| JP 2008-177432 A | 31 Jul. 2008 | (Family: none) | |
| JP 2015-34300 A | 19 Feb. 2015 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6061372 A